# EUROPEAN PATENT APPLICATION

(11) **EP 4 718 959 A1**
(43) Date of publication of application: **01.04.2026**
(21) Application number: 24202631.8
(22) Date of filing: 25.09.2024
(51) Int. Cl.: H05K 7/20

(54) **A COOLING DEVICE AND PCB HOUSING INCORPORATING SAME**

(71) Applicant: Aptiv Technologies AG, 8200 Schaffhausen (CH)
(72) Inventor: MERTEN, Tobias, 40545 Düsseldorf (DE); DENKELMANN, Rainer, 12049 Berlin (DE); YATHURU, Naresh, 42281 Wuppertal (DE)
(74) Representative: Lewis Silkin LLP

(57) **Abstract**

A cooling device (11), comprised of an extruded aluminium profile, has a plurality of longitudinal channels (17) formed therethrough by the extrusion process. The device may serve as an outer wall/lid for a PCB housing (10). The profile (11) includes internally facing projections (18b), e.g. by making impressions (18a) into the opposite surface, located coincident with the channels. The configuration enables contact with electronic components of varying height from a circuit board (14). In use, liquid coolant passing through the channels (17), behind the projections (18b), transfers heat away from electronic components (19) of the PCB (14).

## Description

### Introduction

The present disclosure relates to a cooling device for cooling a plurality of electronic components mounted on a circuit board, and a corresponding housing/enclosure for the circuit board that incorporates the cooling device. The present disclosure is particularly relevant to cold plates for cooling electronic control units for automotive applications.

### Background

Some electronic components get hot during use, which can subsequently compromise their function or lead to component damage. As such, it is common to fit cooling devices to electronic circuitry to maintain their operating temperature within an acceptable tolerance. For particularly high demand applications, liquid cooling systems are often used due to their high cooling efficiency. Conventional liquid cooling systems often have a cold plate, which is a device typically having a flat metal body with an internal circuit of cooling channels or tubes through which coolant fluid may be circulated. In use, the cold plate is fitted against the electronic components and, as components get hot, heat is transferred through the body and cooling tubes into the coolant, and subsequently transported away from the circuit.

Cooling assemblies sometimes have surface features that are configured to project toward and contact against components on the circuit board, especially those that generate the most heat.

A known form of housing for automotive ECUs comprises a die-cast aluminium part and there is a need for liquid cooling for these ECUs for the reasons outlined above. The liquid cooled part of the housing may also be a die-cast part, friction stir welded (FSW) to seal the cavity for the liquid. This process requires a stiffer housing according to the welding process, which generates high forces to the housing.

### Summary

The present disclosure concerns a cooling device, corresponding PCB housing and method for manufacturing a cooling device for cooling a plurality of electronic components mounted on a circuit board. The cooling device may serve as a cold plate for use with an electronic control unit. Particularly, the invention seeks to provide an improved or at least alternative cooling device and corresponding PCB housing/assembly, with a method/process for its construction that is cost and/or operationally effective.

A first aspect of the invention is outlined according to claim 1. Subsidiary features are specified in the dependent claims. For example, a cooling device for cooling a plurality of electronic components mounted on a circuit board, comprises: a profile (e.g. in the form of an extruded relatively flat plate) with at least one channel formed longitudinally therethrough. The invention may alternatively be expressed as a cooling device for cooling a plurality of electronic components mounted on a circuit board in an electronic control unit, comprising: an extruded profile with at least one channel formed longitudinally therethrough between a first edge and a second edge; wherein the extruded profile is configured with a first side to serve as an outer wall of the electronic control unit and a second side to serve as an interface for cooling the plurality of electronic components mounted on the circuit board. In the present context, the terms PCB housing and electronic control unit are synonymous and interchangeable.

There may be at least one feature projecting from a surface of the profile/plate, configured for contacting with an electronic component of a PCB. In embodiments, the projecting (e.g. embossed) feature is formed by pressing a corresponding debossed feature into an opposite surface of the extruded plate, e.g. with a pressing tool. In this way, the longitudinal channel (s) can be used as a path for a cooling liquid to be directed through the extruded profile of the plate, including through a cavity proximate the surface feature, thereby cooling any electronic components in contact with the feature.

The cooling device may be utilised to comprise a wall of an electronic control unit (ECU) which houses a PCB in contact therewith. An opposite wall of the housing may be formed as a pressed metal construction, e.g in the form of a cover or tray, comprising coupling features to fasten the cooling device, e.g. in the form of a plate or lid, thereto with the printed circuit board (PCB) mounted and housed therebetween.

As mentioned, the PCB-mating face of the cooling device/plate may be shaped to have projected (e.g. embossed) regions for mating with some components and recessed (e.g. debossed) regions for mating with other components. The embossed and debossed regions may have different heights and depths depending on the surface to be mated against, i.e. where the electronic components have different heights relative to the substrate material of the PCB.

Importantly, the device provides a simple and light pressed lid construction for a PCB housing from an extruded profile, to serve as a liquid cooled heat exchange device. In a second broad aspect of the invention, a PCB housing is provided that incorporates the cooling device.

In embodiments, as mentioned, the component formations are formed by pressing a forming tool into the extruded plate surface. In other embodiments, the component formations/surface features may be formed by other means and applied onto a surface of the extruded profile.

In one form, a thermal interface material is applied to the embossed (and/or debossed) surface feature, for improved thermal contact with a corresponding electronic component of the PCB.

Advantageously, according to the foregoing, the cooling device is able to perform as at least one complete wall of a PCB housing. In principle, a second cooling device according to the invention may be used as a second wall of the PCB housing, e.g. opposite the first where components extend from both sides of the PCB. One or both the cooling device/plate walls may be pressed to accommodate the PCB itself, in addition to surface components thereon.

According to the invention, the problem of how to integrate an extruded profile cold plate in an ECU housing is recognised and solved by adapting an extruded (e.g. aluminium) profile as a wall of the housing itself.

The extruded profile becomes the lid of the housing that is adapted to be fastened, e.g. screwed, with the PCB and a sheet metal cover to complete the housing. A third aspect of the invention related to a method of construction.

As mentioned, and as with most cooling solutions, a layer of thermal interface material (TIM) is used to connect the hot components to the extruded aluminium profile (housing or cold plate). Preferably, the PCB is designed/dimensioned to fit within the housing and corresponding cooling device. In one form, the outer surface of the aluminium profile is made corrosion resistant.

According to the proposed solution, costs and complexity of the housing are reduced. Also, the weight and size (thickness/height) is reduced to a compact/flat profile.

In some forms, depending on the application, the extruded profile may be stiffened, e.g. by formation of ribs in the extrusion. Further, the profile may be strengthened by making some regions thicker than others, omitting channels at edges thereof and/or filling the channels with a stiffening element.

The opposite side cover of the PCB housing may be formed of pressed stainless steel or zinc plated. The selected material may depend on how much stiffness can be imparted to the extrusion. For example, it is possible to also press ribs into the opposing cover.

A liquid coolant delivery system may be connected directly to the profile, e.g. via clips, gluing or other fasteners. Fluid is urged to flow straight through the channels between an inlet and outlet end. In principle, channels could be configured with flow in one direction and then the other, via a suitable manifold which connects the coolant.

### Brief Description of Drawings

Illustrative embodiments will now be described with reference to the accompanying drawings in which:
Figure 1 illustrates an overview of a PCB housing, incorporating an extruded cooling device;
Figure 2 illustrates an underneath view of the cooling device;
Figure 3 illustrates a further underneath view of the cooling device, showing a PCB in contact with an underside surface thereof; and
Figure 4 illustrates an underneath view of a cover of the housing.

### Detailed Description

The following description presents exemplary embodiments and, together with the drawings, serves to explain principles of the invention. However, the scope of the invention is not intended to be limited to the precise details of the embodiments or exact adherence with all features and/or method steps, since variations will be apparent to a skilled person and are deemed also to be covered by the description. Terms for components used herein should be given a broad interpretation that also encompasses equivalent functions and features. In some cases, several alternative terms (synonyms) for structural features have been provided but such terms are not intended to be exhaustive. Descriptive terms should also be given the broadest possible interpretation; e.g. the term "comprising" as used in this specification means "consisting at least in part of" such that interpreting each statement in this specification that includes the term "comprising", features other than that or those prefaced by the term may also be present. Related terms such as "comprise" and "comprises" are to be interpreted in the same manner. Directional terms such as "vertical", "horizontal", "up", "down", "sideways", "upper" and "lower" are used for convenience of explanation usually with reference to the orientation shown in illustrations and are not intended to be ultimately limiting if an equivalent function can be achieved with an alternative dimension and/or direction. Indeed, in the present case a term such as "horizontal" axis or "vertical" axis can be affected by the orientation imposed on the housing structure. Therefore, all directional terms are relative to each other.

The description herein refers to embodiments with particular combinations of steps or features, however, it is envisaged that further combinations and cross-combinations of compatible steps or features between embodiments will be possible. Indeed, isolated features may function independently as an invention from other features and not necessarily require implementation as a complete combination.

It will be understood that the illustrated embodiments show applications only for the purposes of explanation. In practice, the invention may be applied to many different configurations, where the embodiment is straightforward for those skilled in the art to implement.

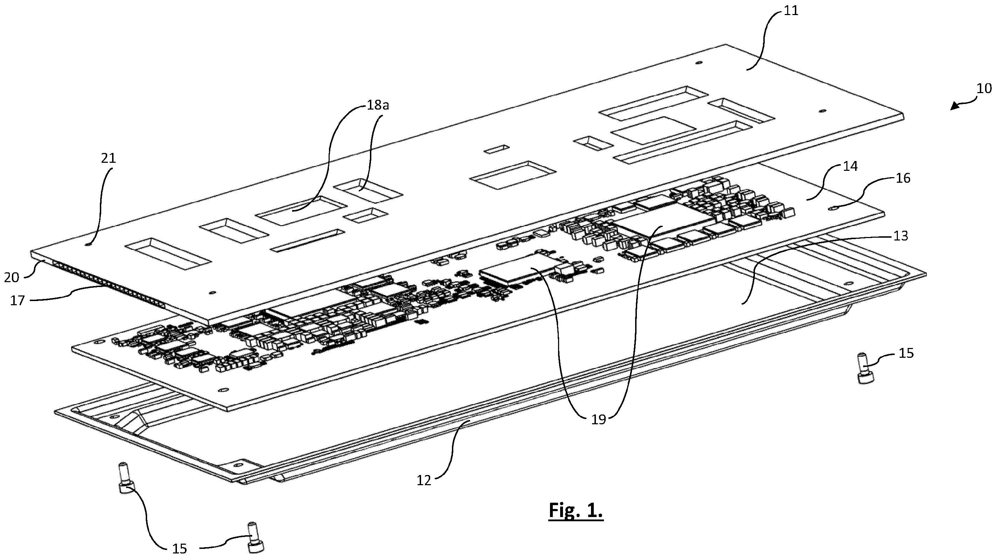

Figure 1 shows a general view of components for a PCB housing 10 incorporating a cooling device 11 according to the invention. Housing 10 comprises the cooling device 11 serving as a lid for attachment to a bottom cover 12 that provides a cavity 13 to accommodate a printed circuit board, PCB 14.

Fasteners 15, e.g. fixing screws, may couple cover 12 to cooling device 11, while passing through openings 16 at corners of the PCB 13. In this way, after assembly, the PCB 14 will be sandwiched in place and protected by the external housing components 11, 12.

It will be apparent from Figure 1 that cover 12 may have a generally shallow cavity 13, e.g. formed by pressing a sheet metal plate into shape. Alternative constructions (e.g. moulded in one or more parts) are possible which are designed to cooperate with the generally plate-like "lid" 11 and house PCB 14 therewithin.

Also apparent from Figure 1 is the plate-like nature of cooling device/lid 11, preferably formed by an extrusion process from aluminium, comprising a plurality of channels 17 longitudinally through its entire length. Each channel 17 is separated by a wall, giving a square or rectangular cross-section, although other section shapes are possible such as circular, hexagonal, etc. In the illustrated form, the multiple channel openings 17 do not extend across the entire end edge 20 of the plate, but may leave channel-less outer edges/regions through which receiving holes 21 are made for the fasteners 15.

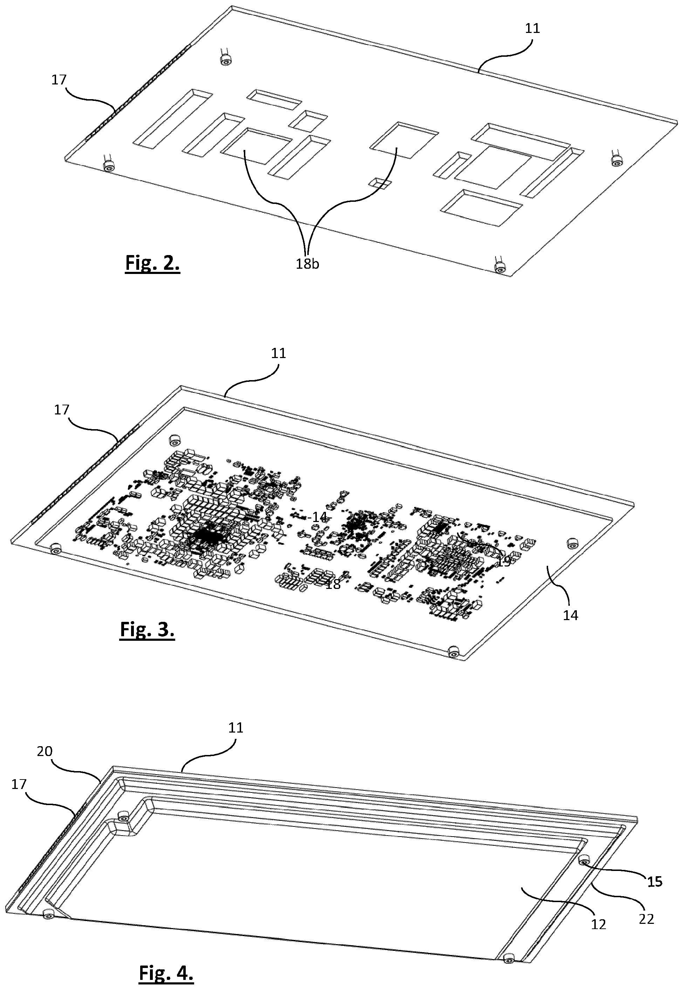

During manufacture, device 11 will initially be extruded as a flat plate, cut to an appropriate length for compatibility with bottom cover 12. Prior to, during or after the cutting process, surface features 18a/18b may be formed/added on the surface of plate 11. Such features preferably coincide/align with the location of one or more electronic components 19 of the PCB 14. In the illustrated form, features 18a may be formed by pressing a die into the outer surface visible in Figure 1 to impress/deboss a shape 18b (in this case, rectangular) which projects from the opposite side of device 11, as shown by Figure 2. The channels 17 are prevented from collapsing during pressing by virtue of production controls and their respective side walls.

Features 18a/18b are formed in the region of the plate surface coinciding with the channels 17 such that, in use, liquid coolant pumped/passing through the channels likewise flows within and/or behind the surface features 18. Thus, when contacted with electronic components 19, projections 18 are configured to dissipate/transfer away heat generated by the components via coolant flowing within the plate 11.

The illustrated form of cooling device 11 shows (embossed) projections 18b from the underside of the plate surface and (debossed) impressions 18a on the upside. In alternative forms, a mixture of debossed and embossed features may be formed on the same side, such as to accommodate a wider range of components heights from the PCB without altering other dimensions.

As mentioned, the preferred method of forming projections 18 is to apply a pressing tool (to one or both sides) which deforms the surface and underlying channels 17 (while maintaining these intact to preserve a coolant flowpath). However, alternative methods are possible, such as additive manufacturing or welding the projections in place. Indeed, projecting or debossed surface features are not necessarily essential to the inventive concept if a flat plate is able to contact (e.g. via a thermal interface material) a plurality of components 19 of similar height.

In any event, thermal interface material is recommended for application to either or both mating surfaces in order to account for any minor gaps/imperfections in contact between the plate 11 and components 19.

Figure 3 shows a step of assembly where the formed plate 11 is brought into contact (e.g. via TIM) with the PCB 14 upper surface which accommodates components 19. The underside of the PCB 14 is visible, prior to fitting of cover 12. It will be apparent that, should components 19 project from both sides of PCB 14, a second plate 11 could be used as the "bottom cover." The two devices, each forming a substantive wall of the PCB housing, could be fixed together, e.g. via a peripheral frame which accommodates a thickness of the PCB, and/or a cavity may be formed via a pressing tool to accommodate PCB 14.

Figure 4 illustrates the assembled housing 10 where bottom cover 12 is in place and aligned with cooling device 11, fixed together by screws 15. Channels 17 are visible, ready for connection to a manifold (not shown) that will supply cooling fluid between first (e.g. left edge 20 in view) and second (e.g. right side edge 22 not visible) edges of the cooling plate 11. PCB 14 is securely housed within and not visible in Figure 4.

By way of summary, the invention is generally embodied by a cooling plate, e.g. that is formed by extruding a profile with integral channels therethrough, and using this cooling plate as a lid/cover for a PCB housing. A slimline housing can be achieved that allows for efficient transfer of excess heat generated by the components of the PCB, via liquid cooling through the plate's channels. Particularly, surface features (e.g. projections and/or depressions) can be formed on the plate that align with the PCB components and, thereby, can account for differences in height thereof while maintaining contact for heat transfer.

In a specific form the disclosure exemplifies a cooling device, comprised of an extruded aluminium profile, that has a plurality of longitudinal channels formed therethrough by the extrusion process. The device may serve as an outer wall/lid for a PCB housing. The profile includes internally facing projections, e.g. by making impressions into the opposite surface, located coincident with the channels. The described configuration enables contact with electronic components of varying height from a circuit board and, in use, liquid coolant passing through the channels, behind the projections, transfers heat away from electronic components of the PCB.

## Claims

1. A cooling device for cooling a plurality of electronic components mounted on a circuit board in an electronic control unit, comprising:
an extruded profile with at least one channel formed longitudinally therethrough between a first end edge and a second end edge for receiving fluid coolant;
wherein the extruded profile is configured with a first side to serve as an outer wall of the electronic control unit and a second side to serve as an interface for cooling the plurality of electronic components mounted on the circuit board.

2. The cooling device of claim 1, further comprising at least one feature projecting from and/or recessed into a surface of the profile coincident with the at least one channel, configured for contacting with a corresponding electronic component of the circuit board.

3. The cooling device of claim 2, wherein the at least one feature is formed by making an impression in one or other of the first and second sides, to form a projection in the opposite side.

4. The cooling device of any preceding claim, wherein there are a plurality of channels, located inboard of a side edge of the extruded profile

5. The cooling device of any preceding claim, comprising a thermal interface material applied to the second side of the profile.

6. A housing for a circuit board, wherein the cooling device of any preceding claim comprises a first wall of the housing, the first wall being configured for cooperation with a second wall or cover to form an enclosure for the circuit board.

7. The housing of claim 6, wherein the second wall or cover is of a pressed metal construction.

8. The housing of claim 6 or 7, further comprising coupling features for aligning and adjoining the first and second walls together, with the printed circuit board mounted and enclosed therebetween.

9. The housing of any preceding claim 5 to 8, further comprising the circuit board.

10. The housing of any preceding claim 5 to 9, further comprising thermal interface material applied for facilitating thermal contact between the circuit board and cooling device.

11. A method of manufacturing a cooling device, comprising steps of:
extruding a profile in a longitudinal direction comprising at least one channel or opening therethrough in the longitudinal direction;
cutting a length of the extruded profile to form a substantially plate-like part.

12. The method of claim 11, comprising the step of forming at least one feature projecting from and/or recessed into a side of the profile coincident with the at least one channel.

13. The method of claim 12, wherein the at least one feature is formed by pressing a tool into one side of the profile, thereby forming a projection in the opposite side.

14. A method of manufacturing an electronic control unit, comprising:
forming a first wall according to the method of manufacturing a cooling device of claim 11 or 12;
forming a second wall by pressing a sheet into a tray shape comprising a cavity;
assembling a circuit board between the first and second wall, to be accommodated by the cavity and in thermal contact with the first wall on one side.

15. The method of claim 14, comprising applying a layer of thermal interface material between mating surfaces of the circuit board and first wall.
